(19) Europäisches Patentamt
European Patent Office
Office européen des brevets

(11) Publication number: **0 040 535**
**B1**

(12) **EUROPEAN PATENT SPECIFICATION**

(45) Date of publication of patent specification: **19.09.84**

(51) Int. Cl.³: **H 01 L 21/302,**
H 01 L 21/312, G 03 F 7/08

(21) Application number: **81302194.6**

(22) Date of filing: **18.05.81**

# (54) Method of forming a microscopic pattern, and a photoresist.

(30) Priority: **19.05.80 JP 65404/80**

(43) Date of publication of application:
**25.11.81 Bulletin 81/47**

(45) Publication of the grant of the patent:
**19.09.84 Bulletin 84/38**

(84) Designated Contracting States:
**DE GB NL**

(56) References cited:
**DE-A-2 421 492**
**DE-B-2 361 436**

(73) Proprietor: **Hitachi, Ltd.**
**5-1, Marunouchi 1-chome**
**Chiyoda-ku Tokyo 100 (JP)**

(72) Inventor: **Matsuzawa, Toshiharu**
**2-24-5 Hagiyama-cho**
**Higashimurayama-shi Tokyo (JP)**
Inventor: **Iwayanagi, Takao**
**2-5-9 Nerima**
**Nerima-ku Tokyo (JP)**
Inventor: **Douta, Kikuo**
**3-16-1 Sennin-cho**
**Hachioji-shi Tokyo (JP)**
Inventor: **Yanazawa, Hiroshi**
**2196-106 Hirai Hinodemachi**
**Nishitamagun Tokyo (JP)**
Inventor: **Kohashi, Takahiro**
**2-32-A201 Koyasu-cho**
**Hachioji-shi Tokyo (JP)**
Inventor: **Nonogaki, Saburo**
**3-17-24 Kamimeguro**
**Meguro-ku Tokyo (JP)**

(74) Representative: **Paget, Hugh Charles Edward et al**
**MEWBURN ELLIS & CO. 2/3 Cursitor Street**
**London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 040 535 B1**

**Description**

This invention relates to a method of forming a microscopic pattern by means of a photoresist and to a photoresist for use in such a method.

As semiconductor devices have achieved high density and a high degree of integration in recent years, a method by which a microscopic pattern 0.5—2μm wide can readily be formed with high precision has become necessary. Various patterns in semiconductor devices have hitherto been formed by a technology called "photolithography", in which exposure to ultraviolet radiation having wavelengths of approximately 320—500 nm and wet etching employing a liquid etchant are commonly practised. However, during exposure of a photoresist film with such ultraviolet ratidion, properties inherent in radiation such as diffraction and interference render it difficult precisely to form a microscopic pattern of 0.5—2 μm width.

When etching by wet etching employing a liquid etchant, the precision of formation of a pattern is reduced by side etching etc. It is for this reason also difficult to form a microscope pattern precisely.

As a consequent of this difficulty it has been proposed to use, for exposure, ultravilet radiation having wavelengths approximately 200—320 nm shorter than the wavelengths of the radiation mentioned above (such radiation of shorter wavelengths is called "far-ultraviolet radiation" in this specification) and to employ, for etching, various dry etching processes using no liquid etchant. This eliminates both the effects of diffraction and interference and reduction of precision by side etching, so that the formation of a highly precise microscopic pattern ought to be possible.

However, it has hitherto been found impossible to achieve sufficiently good results because of the unavailability of any photoresist suitable for both exposure to far-ultraviolet radiation and dry etching.

For example, polymethyl methacrylate (abbreviated to "PMMA") and polymethyl isopropenyl ketone (abbreviated to "PMIPK") are usually used as photoresists for far-ultraviolet radiation. Although these give excellent resolution, they have an insufficient sensitivity to the far-ultraviolet radiation and require a long time for the exposure, and moreover, they have insufficient resistance to dry etching and result in great damage to a resist pattern during dry etching. It has therefore been difficult to put them into practical use. In particular, it is a fatal disadvantage in practice that resistance against dry etching is low.

EP—A—20870 (application date 20th March 1980, publication date 7th January 1981) discloses a photoresist composition comprising a phenolic-aldehyde resin and Meldrum's diazo (2,2-dimethyl-4,6-diketo-5-diazo-1.3-dioxane). There is no difference to dry etching of the desired pattern, after exposure and development of the photoresist.

An object of this invention is thus to provide a microscopic pattern-forming method which can form a microscopic pattern at high precision with exposure to far-ultraviolet radiation and dry etching.

The invention as claimed is intended to provide a solution.

The hitherto-known, positive type photoresists for far-ultraviolet radiation such as PMMA and PMIPK use the property that, when irradiated with the radiation, the polymer of the resist suffers decomposition by rupture of the main chain and so acquires a low-molecular weight, to become readily soluble in liquid developer. If a positive type photoresist having this property is used in dry etching, it can be said that the resistance against dry etching is, in principle, low because the photoresist is liable to be decomposed into the low molecular weight by the irradiating radiation.

On the other hand, a negative type photoresist is quite different from the positive type in the effect on it of radiation, and so its resistance against the dry etching is considered to be much higher. However, this high resistance against dry etching does not mean that all negative type photoresists are usable. Known negative type photoresists which can be used with far-ultraviolet radiation are, for example, chloromethylated polystyrene and a cyclized rubber type resist whose sensitive component is a bisazide having its maximum absorption wavelength in the far-ultraviolet region.

Contrariwise to the positive type photoresists, these negative type photoresists are superior in the resistance against the dry etching and in sensitivity, but are inferior in resolution. It is therefore also difficult to employ them for a formation of a microscopic pattern.

More specifically, these negative type photoresists have the property that when they are irradiated a three-dimentional network is formed by cross-linking to increase molecular weight and render the resist insoluble. Therefore, the resistance against the dry etching is higher than for positive type photoresists.

Known negative type photoresists, however, have the disadvantage that, when the photoresist is dipped in a liquid developer after exposure to form a resist pattern, the exposed part of the pattern is swollen by the liquid developer, so the pattern is prone to meander due to stress during the succeeding drying treatment. It is therefore difficult to make the aspect ratio (the ratio between the residual thickness of the resist pattern after development and the width of a resolvable line) one or greater. By way of example, when the residual thickness of the photoresist is 1 μm, a pattern whose line width and spacing are less than 1 μm cannot be formed.

The present inventors have found that when a polymer having phenolic hydroxyl groups is employed as a photoresist and is irradiated with far-ultraviolet radiation and thereafter developed with an alkaline solution, a photoresist pattern whose resistance against dry etching is high and whose

resolution is very high can be formed. Furthermore, by adding a certain kind of aromatic azide to the polymer having phenolic hydroxyl groups, sensitivity to far-ultraviolet radiation is increased remarkably.

Accordingly, when such a photoresist is exposed by far-ultraviolet radiation and is developed to obtain a photoresist pattern, and a film which is to form a microscopic pattern is etched by dry etching using this photoresist pattern as a mask, the microscopic pattern can be formed having a line width and spacing of approximately 0.5—2 $\mu$m at very high precision.

Examples of this invention will now be given.

Example 1

Polyvinyl phenol and novolac resins (the addition condensation products between phenols and formaldehyde) etc. dissolve in alkaline aqueous solutions, but are rendered insoluble in such solutions when irradiated with far-ultraviolet radiation. Therefore, they can be used as negative type photoresists for far-ultraviolet radiation.

The addition condensation product (novolac resin) between m-cresol and formaldehyde, and poly(p-vinyl phenol) were applied onto silicon substrates separately, were irradiated with far-ultraviolet radiation of intensity 5.5 mW/cm$^2$ at a wavelength of 254 nm, and were dipped in a 2% aqueous solution of tetramethylammonium hydroxide. The relationships between the exposure time to the far-ultraviolet radiation and the corresponding residual resist thickness were measured, and the results are shown by curves 1 and 2 respectively in the single figure of the accompanying drawing. When m-cresol was replaced with other cresols or phenols, substantially the same results were obtained. In addition, when cresols and phenols were jointly used, the results were substantially the same.

The figure shows that both kinds of resin began to become insoluble in the alkaline aqueous solution on exposure to the far-ultraviolet radiation for approximately 40—50 seconds. It is also indicated that, when the exposure time increased, the residual resist thickness also increases, so the insolubility proceeded. With exposure for more than approximately 80 seconds, the residual resist thickness scarcely changed.

This shows that both the poly(p-vinyl phenol) and the novolac resin can be used as negative type photoresist for far-ultraviolet radiation. Moreover as the figure shows, they have high contrast with respect to the amount of exposure.

Therefore, repetition patterns in which both the line width and spacing were 1 $\mu$m could be precisely formed using these resins. Observation with a scanning electron microscope has revealed that the side surfaces of the patterns obtained in this example were more abrupt than with prior-art photoresists.

Whereas, as mentioned, the prior art, negative type photoresists swell in the development step, the photoresists of this example exploit insolubilization and do not rely on any cross linking reaction. Thus, swelling and meandering are not to be feared.

To test resistance against dry etching, the photoresists were etched for 20 minutes by reactive sputtering (2.25 A, 20 Pa) using a mixed gas consisting of $C_4F_8$:He = 1:1 (volumetric ratio). Their weight reductions for exposure for 100 seconds by the radiation source mentioned above were 23%. This result is better than the weight reduction of 35% achieved under the same conditions of AZ1350J (trade name of a product of Shipley Inc.) which is said to exhibit the highest resistance against dry etching among prior art photoresists. Together with the abrupt sectional shape, this weight reduction rate makes the photoresist very suitable for dry etching.

Not only the above-mentioned two kinds of polymer but other polymers which are soluble in alkaline aqueous solution and have phenolic hydroxyl groups such as bromides of poly(vinyl phenol), poly(vinyl hydroxybenzoate) and poly(vinyl hydroxybenzal) can be used.

Example 2

Phenol type and cresol type novolac resins, polyvinyl phenol, polyisopropenyl phenol, etc. were used as alkali-soluble high polymers having phenolic hydroxyl groups, and were respectively irradiated with far-ultraviolet radiation and developed with alkaline solutions. Satisfactory resist patterns which had very high dry etching-immunity were formed.

When certain kinds of aromatic azides are added to these compounds, sensitivity to far-ultraviolet radiation can be remarkably increased, and very favourable characteristic meeting the desired requirements of high sensitivity, high resolution and dry etching resistance can be attained.

Aromatic azides which are used for this purpose in this invention desirably exhbit maximum absorption in the far-ultraviolet region of wavelengths of approximately 200—320 nm and do not have any high absorption in a region of wavelengths of above approximately 320 nm. High absorption in the far-ultraviolet region is required to obtain high sensitivity to far-ultraviolet radiation. For the following two reasons, high absorption in the region above 320 nm should be absent.

Firstly, if the photoresist film is irradiated with the radiation of wavelengths longer than those of the far-ultraviolet radiation on account of an unsatisfactory filter for the radiation spectrum of a lamp used for exposure, high absorption in the longer wavelength region will cause degradation of the resolution.

Secondly, if radiation of the wavelengths above 320 nm is absorbed, all the handling of the

photoresist can be carried out under ordinary illumination, and a yellow safety light may be dispensed with.

Among aromatic azides satisfying such requirements, those having the following general formula (1) are preferred in practice:

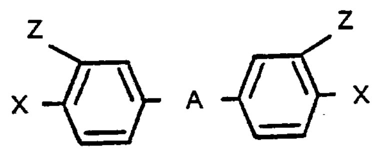

(1)

A is an element or subsituent non-conjugating with the two benzene rings, such as O, S, $CH_2$ $CH_2CH_2$, $SO_2$ and $S_2$; X is H or $N_3$; and Z is $N_3$ when X is H and H or Cl when X is $N_3$. In order that maximum absorption may be exhibited in the far-ultraviolet region (wavelengths 200—320 nm) and high absorption is not exhibited beyond 320 nm, A in this structure should as stated not conjugate with the benzene rings.

Among azides having only one benzene ring, there are some fulfilling the requirements mentioned above. However, they have the disadvantage that, since they have low boiling points, they volatilize in a prebaking step which is carried out before exposure. Azides of formula (1) are more favourable in practice.

Example 3:

A photoresist was prepared by dissolving 20 g of a novolac resin produced by copolymerization of phenol and m-cresol and 4 g of 4,4'-diazidediphenylsulfide in 80 g of methyl cellusolve acetate. This solution was applied by spin coating onto a phosphosilicate glass film 0.5 $\mu$m thick deposited on a silicon wafer and was dried, to form a photoresist film approximately 0,9 $\mu$m thick.

Using a xenon-mercury-vapor lamp of 500 W as a radiation source, the photoresist film was exposed to radiation for 1.5 seconds through a chromium mask formed on a synthetic quartz substrate. To eliminate the longer wavelength radiation and prevent the wafer from being heated by infrared radiation, a cold mirror adapted to absorb radiation of wavelengths longer than 300 nm was used to reflect only the radiation of wavelengths of and below 300 nm, and the photoresist film was exposed to the reflected radiation.

The photoresist film thus exposed to far-ultraviolet radiation of wavelength 200—300 nm was developed by an aqueous solution containing 2% of tetramethyl-ammonium hydroxide as alkaline component, to dissolve and remove the unexposed part of the photoresist film. In this way, a rectilinear repetition photoresist pattern having a line width of 1 $\mu$m and a spacing of 1 $\mu$m could be formed with very high precision.

Using the photoresist pattern as a mask, the resultant wafer was etched for 10 minutes in a reactive sputter-etching equipment (2.25 A, 20 Pa) which employed a mixed gas consisting of $C_4F_8$: He = 1:1. A repetition pattern of phosphosilicate glass faithful to the mask of resist was obtained.

A pattern was formed by similar operations using PMMA and far-ultraviolet radiation. An exposure for about 300 seconds was necessary to form a good photoresist pattern. The resist of the invention thus required an exposure time of only 1/200 of that of the prior art.

PMMA is a photodecomposing positive type photoresist and is therefore of low resistance against dry etching. A good microscopic pattern of a silicon oxide film could not be formed.

Example 4

A photoresist was prepared by dissolving 20 g of poly(p-vinyl phenol) (produced by Maruzen Sekiyu Kabushiki-Kaisha, trade name: Maruzen Resin M) and 4 g of 3,3'-diazidediphenylsulfone in 80 g of methyl cellosolve acetate. Using this solution a pattern was formed similarly as in Example 3 (except that the exposure time was 2 seconds). As in Example 3, a good microscopic pattern was obtained.

Example 5

A photoresist film of the composition used in Example 4 was formed by the method of Example 3, and was irradiated with far-ultraviolet radiation. In this case, however, the photoresist film was irradiated over the whole surface without employing any mask, and the exposure time was 2 seconds.

The resultant photoresist film was etched by the reactive sputtering using a mixing gas (0.2 Torr) consisting of $C_4F_8$ and He at 1:1 as etching gas. The weight reduction in the etching was measured to be 22%.

For comparison, with the prior art photoresist AZ1350J produced by Shipley Inc. mentioned above, the rate of weight reduction was in reactive sputter-etching was measured under the same conditions, and a value of 35% was obtained.

It is thus to be noted that the photoresist of the present example of the invention is about 1.5 times as good as the known photoresist previously thought best from the point of view of resistance against dry etching.

Example 6:

As stated above, it is preferred that the aromatic azide optionally used in the present invention has the structure of formula (1). Some aromatic azides having such a structure are listed in Table 1. All these have their maximum absorptions in the far-ultraviolet region as is apparent from Table 1, and they all produced good results when applied in this invention.

TABLE 1

| Designation | Structural formula | Max. absorption wave-length (nm) | Melting point (°C) |
|---|---|---|---|
| 4,4'-diazidediphenyl-sulfide | 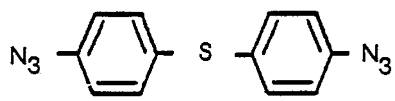 | 273 | 90 |
| 4,4'-diazidediphenyl-sulfone | 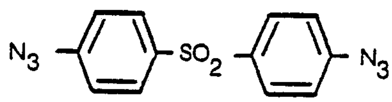 | 284 | 163 |
| 3,3'-diazidediphenyl-sulfone | 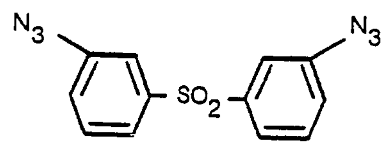 | 240 | 116 |
| 4,4'-diazidediphenyl-methane | 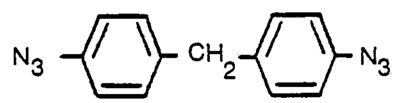 | 256 | 44 |
| 3,3'-dichloro-4,4'-diazidediphenylmethane | 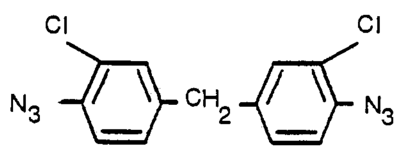 | 258 | 128 |
| 4,4'-diazidediphenyl-ether | 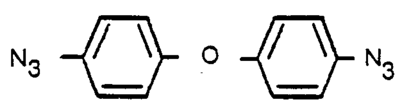 | 264 | 77 |
| 4,4'-diazidediphenyl-disulfide | 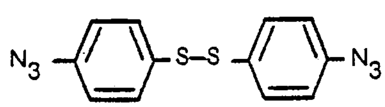 | 266 | 37 |
| 4,4'-diazidebibenzyl | 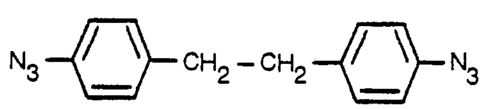 | 254 | 80 |

As the high molecular compound used in this invention, a polymer having phenolic hydroxyl groups can as stated above, be employed. Such polymers include novolac resins (the addition condensation products between phenols or cresols and formaldehyde), polyvinyl phenol, polyisoprophenyl, etc. All have produced good results when used in this invention.

The liquid developer used in this invention may be an alkaline aqueous solution obtained by dissolving, for example, sodium hydroxide, potassium hydroxide, sodium phosphate, sodium silicate, or tetramethylammonium hydroxide in water. With an organic solvent the exposed area of the photoresist dissolved partly, or it swells to some extent even when it does not dissolve. The use of an organic solvent is therefore unfavourable in that the precise formation of a microscopic pattern is difficult.

As is well known, the presence of sodium or potassium ions is extremely unfavourable for the fabrication of semiconductor devices; when this invention is applied to the production of semiconductor devices, a liquid developer which contains neither sodium nor potassium is selected. However, when using this invention for the production of a magnetic bubble memory device, liquid developers which contain sodium and potassium (e.g. forms a sodium hydroxide and potassium hydroxide) can be used because the presence of sodium and potassium is no hindrance.

The concentrations, temperatures and developing times of these liquid developers vary considerably, of course, depending upon many factors including the kind of the liquid developer used, the kind of photoresist, the thickness of the resist film, etc. but rough guides are 0.1—10 weight % for concentration, 10—40°C for temperature and 10—600 seconds for development time.

The dry etching may be a well known process such as plasma etching using cyclindrical type plasma etching equipment or parallel plate type plasma etching equipment, reactive sputter etching, sputter etching or microwave plasma etching.

To summarize, by this invention, exposure to far-ultraviolet radiation and dry etching can be effectively utilized, so that a microscopic pattern can be formed even at an extraordinarily high precision. The invention is especially useful for the production of semiconductor devices of high packaging densities and magnetic bubble memory devices.

## Claims

1. A method of forming a microscopic pattern, including:

(1) forming a photoresist film on a layer of a substance which is to form the microscopic pattern, the photoresist film consisting of an alkali-soluble high molecular weight compound having phenolic hydroxyl groups,

(2) irradiating a part of said photoresist film with far-ultraviolet radiation, to lower the alkali-solubility of the irradiated part,

(3) developing the irradiated photoresist film with an alkaline aqueous solution, to remove the unirradiated part of said photoresist film and thereby to form a photoresist pattern, and

(4) dry etching said substance using said photoresist pattern as a mask, to form said microscopic pattern of said substance.

2. A method according to claim 1 wherein the photoresist contains at least one aromatic azide which increased the sensitivity of the photoresist to far-ultraviolet radiation.

3. A method according to claim 1 or claim 2 wherein the photoresist contains an aromatic azide of the formula:

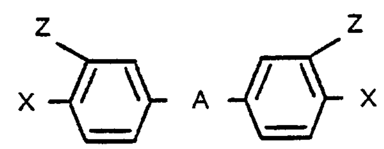

wherein A is an element or substituent non-conjugating with the two benzene rings, X is H or $N_3$, and Z is $N_3$ when X is H or N or Cl when X is $N_3$.

4. A method according to claim 3 wherein said aromatic azide is one or more of
4,4′-diazidediphenylsulfide,
4,4′-diazidediphenylsulfone,
3,3′-diazidediphenylsulfone,
4,4′-diazidediphenylmethane,
3,3′-dichloro-4,4′-diazidediphenylmethane,
4,4′-diazodediphenylether,
4,4′-diazidediphenylsulfide, and
4,4′-diazidebibenzyl.

5. A method according to any one of claims 1 to 4 wherein said high molecular weight compound is one or more of novolac resins produced from formaldehyde and phenols, polyvinyl phenol, bromides of polyvinyl phenol, and polyisopropenyl phenol.

6. A method according to any one of the preceding claims wherein said alkaline aqueous solution is one or more of sodium hydroxide, potassium hydroxide, sodium phosphate, sodium silicate, and tetraalkylammonium hydroxide.

7. A photoresist comprising a high molecular weight compound having phenolic hydroxyl groups

and at least one aromatic azide which increases the sensitivity of the photoresist to far-ultraviolet radiation.

**Patentansprüche**

1. Verfahren zur Ausbildung eines mikroskopischen Musters, welches umfaßt:

(1) Die Ausbildung eines Photoresistfilms, der aus einer alkalilöslichen hochmolekularen Verbindung mit phenolischen Hydroxylgruppen besteht, auf einer Schicht aus einer Substanz, welche das mikroskopische Muster bilden soll,

(2) Belichten eines Teils dieses Photoresistfilms mit ferner Ultraviolettstrahlung, um die Alkalilöslichkeit des bestrahlten Teils zu vermindern,

(3) Entwickeln des belichteten, Photoresistfilms mit einer wässrig-alkalischen Lösung, um den nicht belichteten Teil des Photoresistfilms zu entfernen und auf diese Weise ein Photoresist-Muster auszubilden, und

(4) Trockenätzen der Substanz unter Anwendung des Photoresist-Musters als Maske, wobei das mikroskopische Muster aus dieser Substanz ausgebildet wird.

2. Verfahren nach Anspruch 1, bei dem das Photoresist mindestens ein aromatisches Azid enthält, welches die Empfindlichkeit des Photoresists gegenüber ferner Ultraviolettstrahlung erhöht.

3. Verfahren nach Anspruch 1 oder 2, bei dem das Photoresist ein aromatisches Azid der Formel

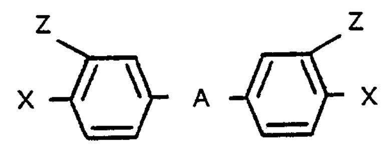

enthält, in der A ein Element oder einen Substituenten, das bzw. der mit den beiden Benzolringen nicht konjugiert, bedeutet, X für H oder $N_3$ steht und Z für $N_3$ steht, wenn X H bedeutet oder für H oder Cl steht, wenn X $N_3$ bedeutet.

4. Verfahren nach Anspruch 3, bei dem das aromatische Azid eine oder mehr der folgenden Verbindungen ist:

4,4'-Diaziddiphenylsulfid,
4,4'-Diaziddiphenylsulfon,
3,3'-Diaziddiphenylfulfon,
4,4'-Diaziddiphenylmethan,
3,3'-Diazoddiphenylsulfon,
4,4'-Diaziddiphenylether,
4,4'-Diaziddiphenylsulfid, und
4,4'-Diaziddibenzyl.

5. Verfahren nach einem der Ansprüche 1 bis 4, bei dem die hochmolekulare Verbindung ein oder mehrere Novolakharze bedeutet, die aus Formaldehyd und Phenolen, Polyvinylphenol, Bromiden des Polyvinylphenols und Polyisopropenylphenol erhalten wurden.

6. Verfahren nach einem der vorhergehenden Ansprüche, bei dem die wässrige-alkalische Lösung eine oder mehre der Verbindungen Natriumhydroxid, Kaliumhydroxid, Natriumphosphat, Natriumsilikat und Tetraalkylammoniumhydroxid ist.

7. Photoresist, welches eine hochmolekulare Verbindung mit phenolischen Hydroxylgruppen und mindestens ein aromatisches Azid, welches die Empfindlichkeit des Photoresist gegenüber einer Ultraviolettstrahlung erhöht, umfaßt.

**Revendication**

1. Procédé pour former un échantillon microscopique, consistant à:

(1) former une pellicule de vernis photosensible sur une couche d'une substance qui doit former l'échantillon microscopique, la pellicule de vernis photosensible consistant en un composé de fort poids moléculaire soluble dans les alcalis ayant des groupes hydroxyles phénoliques,

(2) irradier une partie de ladite pellicule de vernis photosensible avec un rayonnement ultraviolet. lointain, pour abaisser la solubilité dans les alcalis de la partie irradiée,

(3) développer la pellicule de vernis photosensible irradiée au moyen d'une solution alcaline aqueuse, pour retirer la partie non irradiée de ladite pellicule de vernis photosensible et former ainsi un motif du vernis photosensible, et,

(4) attaquer à sec ladite substance en utilisant ledit motif du vernis photosensible comme masque, pour former ledit échantillon microscopique de ladite substance.

2. Procédé selon la revendication 1, où le vernis photosensible contient au moins un azide aromatique qui a augmenté la sensibilité du vernis photosensible jusqu'au rayonnement ultraviolet lointain.

3. Procédé selon la revendication 1 ou la revendication 2, où le vernis photosensible contient un azide aromatique de formule:

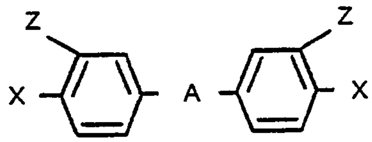

où A est un élément ou substituant ne se conjuguant pas avec les deux noyaux benzène, X est H ou $N_3$ et Z est $N_3$ quand X est H et H ou Cl quand X est $N_3$.

4. Procédé selon la revendication 3, où ledit azide aromatique est un ou plusieurs parmi
4,4'-diazidediphénylsulfure,
4,4'-diazidediphénylsulfone,
3,3'-diazidediphénylsulfone,
4,4'-diazidediphénylméthane,
3,3-dichloro-4,4'-diazidediphénylméthane,
4,4'-diazidediphényléther,
4,4-diazidediphénylsulfure, et
4,4'-diazidedibenzyle.

5. Procédé selon l'une quelconque des revendications 1 à 4, où ledit composé de fort poids moléculaire est un ou plusieurs parmi des résines novolaques produites à partir de formaldéhyde et de phénols, de polyvinyl phénol, de bromures de polyvinyl phénol et de polyisopropényl phénol.

6. Procédé selon l'une quelconque des revendications précédentes, où ladite solution alcaline aqueuse est une ou plusieurs parmi la soude, la potasse, le phosphate du sodium, le silicate de sodium et l'hydroxyde de tétraalkylammonium.

7. Vernis photosensible comprenant un composé de fort poids moléculaire ayant des groupes hydroxyles phénoliques et au moins un azide aromatique qui augmente la sensibilité du vernis photosensible à un rayonnement ultraviolet lointain.

FIG. 1

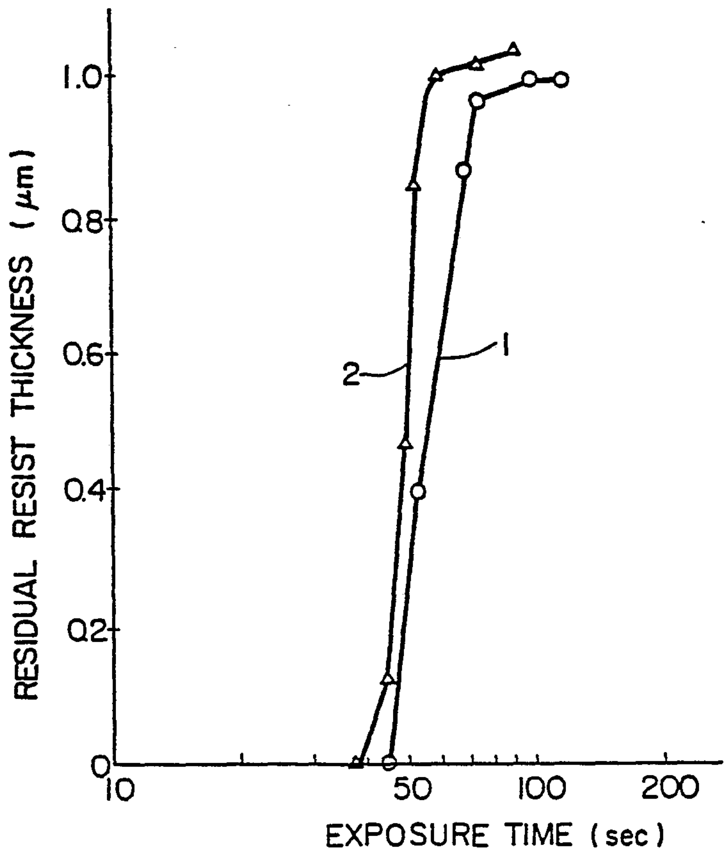
1.0
0.8
0.6
0.4
0.2
0
RESIDUAL RESIST THICKNESS (μm)
2
1
10
50
100
200
EXPOSURE TIME (sec)